# EUROPÄISCHE PATENTSCHRIFT

(11) **EP 1 190 485 B1**
(45) Veröffentlichungstag und Bekanntmachung des Hinweises auf die Patenterteilung: **02.05.2003**
(21) Anmeldenummer: 00949129.1
(22) Anmeldetag: 26.06.2000
(51) Int. Cl.: H03H 17/02

(54) **PROGRAMMIERBARES DIGITALES BANDPASS-FILTER FÜR EINE KODEC-SCHALTUNG**
PROGRAMMABLE DIGITAL BANDPASS FILTER FOR A CODEC CIRCUIT
FILTRE PASSE-BANDE PROGRAMMABLE POUR UN CIRCUIT CODEC

(30) Priorität: 25.06.1999 DE 19929169
(43) Veröffentlichungstag der Anmeldung: 27.03.2002
(73) Patentinhaber: Infineon Technologies AG, 81669 München (DE)
(72) Erfinder: KOGLER, Manfred, A-8052 Graz (AT)
(74) Vertreter: Barth, Stephan Manuel, Dr.
(86) Internationale Anmeldenummer: DE0002065
(87) Internationale Veröffentlichungsnummer: WO01001570

(56) Entgegenhaltungen:
- EP-A- 0 322 060
- EP-A- 0 620 641
- EP-A- 0 703 564
- DE-C- 19 738 226
- US-A- 5 212 817

## Beschreibung

Die vorliegende Erfindung betrifft eine Kodec-Schaltung mit einem programmierbaren digitalen Bandpaß-Filter zur Anpassung der Filtereigenschaften der Kodec-Schaltung an ein übertragenes PCM-Signal.

Die US-A-5,212,817 offenbart eine Kodec-Schaltung mit einem programmierbaren digitalen Bandpaß-Filter zur Anpassung der Filtereigenschaften, wobei die Einstell-Filterkoeffizienten zur Veränderung einer Bandpaß-Filtercharakteristik des programmierbaren digitalen Bandpaßfilters einstellbar sind.

Eine Kodec-Schaltung ist eine Schaltung, welche die Funktionen einer Kodierungsschalteinrichtung und einer Dekodierungsschalieinrichtung in sich vereint. Bei Übertragung von Informationen werden diese in vielen Fällen zwischen zwei Anschlüssen in beide Richtungen übertragen. Die Kodec-Schaltung führte dabei eine PCM(Puls Code Modulation)-Signalkodierung in Senderichtung und eine PCM-Signaldekodierung in Empfangsrichtung vor.

Die praktische Realisierung von Kodec-Schaltungen erfolgt üblicherweise durch digitale Signalprozessoren (DSP: Digital Signal Processor), bei denen es sich um hochspezialisierte aber dennoch standardisierte und in Großserie hergestellte integrierte Schaltungen zur schnellen Bearbeitung einer eng begrenzten Menge von Eingangssignalen in Echtzeit handelt. Derartige digitale Signalprozessoren werden typischerweise bei der Datenübertragung mittels Modems eingesetzt. Ein Modem ist ein Endgerät, das abgehende Signale moduliert und empfangene Signale demoduliert.

Bei der Signalübertragung von Sprechsignalen müssen die Filtereigenschaften der Kodec-Schaltung spezielle vorgegebene Spezifikationen erfüllen. Derartige Spezifikationen bezüglich der Filtereigenschaften bestehen bei der Signalübertragung von Modem-Signalen nicht.

Da die Übertragungsrate der Modems direkt proportional zu der Übertragungs-Freqenzbandbreite ist, erhöht sich mit zunehmender Frequenz-Bandbreite der in der Kodec-Schaltung integrierten digitalen Filter die Datenübertragungsrate. Die digitalen Filter, die bisher bei bekannten Kodec-schaltungen eingesetzt werden, sind bezüglich ihrer Filtereigenschaften an die Spezifikationen, die bezüglich der Übertragung von Sprachsignalen bestehen, angepaßt und nicht programmierbar. Bei derartigen digitalen Filter für Kodec-Schaltungen nach dem Stand der Technik besteht daher keine Möglichkeit, die Filter-Bandbreite zur Datenübertragung zu erweitern bzw. neu einzustellen, wenn anstatt der üblichen Sprechsignale, die beispielsweise von einem Telefonapparat stammen, Modemsignale von einem ersten Modem zu einem zweiten Modem übertragen werden.

Es ist daher die Aufgabe der vorliegenden Erfindung, eine Kodec-Schaltung zu schaffen, bei dem der Datenübertragungs-Frequenzbereich an das übertragene PCM-Signal angepaßt werden kann.

Diese Aufgabe wird erfindungsgemäß durch den Gegenstand mit den im Patentanspruch 1 angegebenen Merkmalen gelöst.

Weitere vorteilhafte Ausgestaltungen sind in den Unieransprüchen angegeben.

Der Erfindung liegt dabei die Idee zugrunde, neben den festeingestellten digitalen Filtern der Kodec-Schaltung das programmierbare digitale Bandpaß-Filter vorzusehen, damit die Filter-Bandbreite und somit die Datenübertragungsrate an das übertragene PCM-Signal angepaßt werden kann.

Bei einer vorteilhaften Ausgestaltung der Kodec-Schaltung gemäß der Erfindung sind die Einstell-Filterkoeffizienten in Koeffizienten-Speichereinrichtungen abspeicherbar, die dem digitalen Hochpaß- und dem digitalen Tiefpaß-Filter zugeordnet sind.

Dies bietet den besonderen Vorteil, daß die Koeffizienten der digitalen Filter jeder Zeit an die technischen Anforderungen des Übertragungskanals und an das übertragene PCM-Signal angepaßt bzw. umprogrammiert werden können.

Bei einer weiteren vorteilhaften Ausgestaltung sind die Speichereinrichtungen wahlfreie Zugriffspeicher (RAMs).

Vorzugsweise sind die Speichereinrichtungen über Koeffizienten-Einstelleitungen mit einer Signal-Erkennungseinrichtung zur Identifikation des durch die Kodec-Schaltung übertragenen PCM-Signals verbunden.

Dies bietet den besonderen Vorteil, daß die Einstellung der Einstell-Filterkoeffizienten und somit die Anpassung der Filtereigenschaften der Kodec-Schaltung an das übertragene PCM-Signal automatisch durch die Identifikation der Art des übertragenen PCM-Signals erfolgen kann, ohne daß eine manuelle Programmierung für den Einzelfall erfolgen muß.

Die programmierbaren digitalen Filter sind vorzugsweise Filter siebter Ordnung.

Bei einer bevorzugten Ausführungsform ist die obere und die untere Signalübertragungs-Grenzfrequenz des digitalen Bandpaß-Filters sowie die Steilheit der Bandpaß-Filterflanken durch die Einstell-Filterkoeffizienten getrennt einstellbar.

Dies bietet den besonderen Vorteil, daß die beiden Signal-übertragungs-Grenzfrequenzen des Bandpaß-Filters unabhängig von einander einstellbar sind. Darüber hinaus kann die Steilheit der Bandpaß-Filterflanken entsprechend den Anforderungen an den Übertragungskanal programmiert werden.

Vorzugsweise ist die untere Signalübertragungs-Grenzfrequenz des Bandpaß-Filters durch Einstellung der Einstell-Filterkoeffizienten des digitalen Hochpaß-Filters einstellbar.

Vorzugsweise ist die obere Signalübertragungs-Grenzfrequenz des Bandpaß-Filters durch Einstellen der Einstell-Filterkoeffizienten des digitalen Tiefpaß-Filters einstellbar. Bei einer bevorzugten Ausführungsform ist in Reihe zu dem digitalen Tiefpaß-Filter und dem digitalen Hochpaß-Filter zusätzlich ein Frequenzgangkorrektur-Filter zum Ausgleich der Welligkeit im Durchlaß-Frequenzbereich des Bandpaß-Filters geschaltet.

Dies bietet den besonderen Vorteil, daß das übertragene PCM-Signal im Durchlaß-Frequenzbereich des Bandpaß-Filters unabhängig von der Frequenz gleichmäßig gefiltert wird. Im weiteren wird eine bevorzugte Ausführungsform einer Kodec-Schaltung zur Erläuterung erfindungswesentlicher Merkmale unter Bezugnahme auf die beigefügten Zeichnungen beschrieben:
Fig. 1 eine Kodec-Schaltung, bei der programmierbare digitale Bandpaß-Filter gemäß der Erfindung sowohl im Sendesignalpfad als auch im Empfangssignalpfad der Kodec-Schaltung eingesetzt sind;
Fig. 2 ein Blockschaltbild der erfindungsgemäßen Kodec-Schaltung;
Fig. 3 eine typische Filtercharakteristik einer Kodec-Schaltung in Abhängigkeit der zugeschalteten Filter im Sendesignalpfad der Kodec-Schaltung;
Fig. 4 eine Filter-Übertragungscharakteristik einer Kodec-Schaltung im Bereich der unteren Grenzfrequenz für verschiedene Filter-Koeffizienteneinstellungen;
Fig. 5 eine Filter-Übertragungscharakteristik einer Kodec-Schaltung im Bereich der oberen Grenzfrequenz.

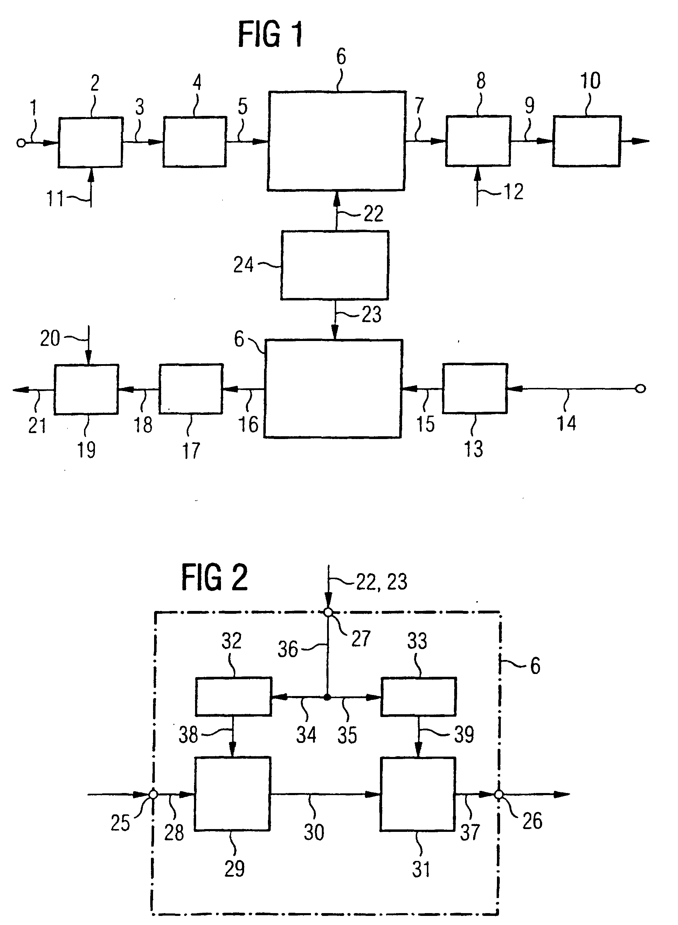

Fig. 1 zeigt ein Blockschaltbild einer Kodec-Schaltung, bei der ein Sendesignal PCM-kodiert wird und ein empfangenes PCM-Signal dekodiert wird. Hierzu weist die Kodec-Schaltung einen Sendesignalpfad und einen Empfangssignalpfad auf.

Ein von einem Telefonapparat oder einem Sende-Modem stammendes Sendesignal wird über eine Eingangsleitung 1 an ein analoges Vorfilter 2 angelegt. Bei dem analogen Vorfilter handelt es sich vorzugsweise um ein analoges Hochpaß-Filter zur Wechselsignal-Auskopplung. Ausgangsseitig ist das analoge Vorfilter 2 über eine Leitung 3 mit einem Analog-Digitalwandler 4 verbunden. Der Analog-Digitalwandler 4 tastet das ihm über die Leitung 3 zugeführte gefilterte analoge Signal ab und erzeugt ein digitales Ausgangssignal, das über die Leitung 5 dem programmierbaren digitalen Bandpaß-Filter 6 gemäß der Erfindung zugeleitet wird. Das digitale Bandpaßfilter 6 weist eine Bandpaß-Filtercharakteristik auf und filtert das an der Leitung 5 anliegende digitale Signal derart, daß lediglich Signale im Durchlaß-Frequenzbereich des Bandpaß-Filters über eine Leitung 7 zu einem digitalen Hochpaß-Filter 8 gelangen. Das digitale Hochpaß-Filter weist eine fest eingestellte nicht veränderbare Hochpaß-Filtercharakteristik auf. Ausgangsseitig ist das digitale Hochpaß-Filter 8 über eine Leitung 9 mit einem Frequenzgangkorrektur-Filter 10 verbunden. Das Frequenzgangkorrektur-Filter 10 gleicht Welligkeiten im Durchlaßbereich der Bandpaß-Filterscharakteristik (sogenannte Ripples) aus.

Der Sendesignalpfad der Kodec-Schaltung wird, wie aus Fig. 1 hervorgeht, durch das analoge Vorfilter 2, den Analog-Digitalwandler 4, das programmierbare digitale Bandpaß-Filter 6, den fest eingestellten digitalen Hochpaß-Filter 8 und durch das Frequenzgangkorrektur-Filter 10 gebildet. Dabei ist das analoge Vorfilter 2 und das fest eingestellte digitale Hochpaß-Filter 8 über Steuerleitungen 11, 12 in den Sendesignalpfad der Kodec-Schaltung schaltbar. Wird das Vorfilter 2 über die Steuerleitung 11 ausgeschaltet, gelangt das an der Eingangsleitung 1 anliegende Signal direkt ungefiltert an den Eingang des Analog-Digitalwandlers 4. Ist das digitale Hoch paß-Filter 8 über die Steuerleitung 12 ausgeschaltet, gelangt das Ausgangssignal des programmierbaren digitalen Bandpaß-DFilters 6 direkt zu dem Frequenzgangkorrektur-Filter 10.

Der Empfangssignalpfad der in Fig. 1 dargestellten Kodec-Schaltung weist ebenfalls einen Frequenzgangkorrektur-Filter 13 auf, das eingangsseitig an einer Empfangsleitung 14 angeschlossen ist. Der Aufbau des Frequenzgangkorrektur-Filters 13 ist demjenigen des Frequenzgangkorrektur-Filters 10 ähnlich. Eine Leitung 15 verbindet ein in dem Empfangssignalpfad der Kodec-Schaltung geschaltetes programmierbares digitales Bandpaß-Filter 6 gemäß der Erfindung mit dem Frequenzgangkorrektur-Filter 13. Das durch das programmierbare digitale Bandpaß-Filter 6 gefilterte Ausgangssignal wird über eine Leitung 16 einem Digital-Analogwandler 17 zugeführt, der das empfangene digitale Signal in ein Analogsignal umwandelt und dies vorzugsweise über eine Leitung 18 an ein analoges Nachfilter 19 abgibt. Das analoge Nachfilter 19 ist bei einer bevorzugten Ausführungsform über eine Steuerleitung 20 in den Empfangssignalpfad der Kodec-Schaltung schaltbar. Das Ausgangssignal des Nachfilters 19 wird über eine Ausgangsleitung 21 beispielsweise an eine nicht-dargestellte SLIC-Schaltung abgegeben.

Die beiden programmierbaren digitalen Bandpaß-Filter der Kodec-Schaltung zur Anpassung der Filtereigenschaften der Kodec-Schaltung an das in dem Sendesignalpfad oder dem Empfangssignalpfad übertragene PCM-Signal sind bei der in Fig. 1 dargestellten bevorzugten Ausführungsform über Steuerleitungen 22, 23 durch eine Signal-Erkennungseinrichtung 24 steuerbar.

Die Signal-Erkennungseinrichtung 24 identifiziert das durch die Kodec-Schaltung übertragene PCM-Signal. Die Signal-Erken nungseinrichtung 24 ist über nicht-dargestellte Erfassungsleitungen an den Sendesignalpfad und/oder an den Empfangssignalpfad der Kodec-Schaltung angeschlossen. In einer in der Signal-Erkennungseinrichtung 24 integrierten Auswerteschaltung wird das in dem Sendesignalpfad oder dem Empfangssignalpfad anliegende PCM-Signal ausgewertet und identifiziert. Die Auswerteschaltung erkennt die Art der Modulation sowie die Übertragungsgeschwindigkeit, so daß einerseits festgestellt werden kann, ob das übertragene PCM-Signal von einem Endgerät, beispielsweise einem Modem, oder von einem Telefon zur Sprachübertragung stammt. Darüber hinaus erkennt die Auswerteschaltung die Art des sendenden oder des empfangenden Modems. Beispielsweise erkennt die Auswerteschaltung, ob das sendende Modem ein V.90-Modem oder ein V.34-Modem ist. Entsprechend dem erkannten Modem stellt die Signal-Erkennungseinrichtung 24 über die Steuerleitungen 22, 23 die digitalen Filterkoeffizienten der digitalen Bandpaß-Filter optimal ein. Die Einstellung der Filterkoeffizienten geschieht dabei vorzugsweise automatisch.

Fig. 2 zeigt die in Fig. 1 dargestellten programmierbaren digitalen Bandpaß-Filter gemäß der Erfindung im Detail.

Das programmierbare digitale Bandpaß-Filter 6 weist einen Eingangsanschluß 25, einen Ausgangsanschluß 26 und einen Steuer- bzw. Einstellanschluß 27 auf. Der Steueranschluß 27 ist über eine Steuerleitung 22 bzw. 23 an die in Fig. 1 gezeigte Signal-Erkennungseinrichtung 24 angeschlossen. Der Eingangsanschluß 25 ist über eine interne Eingangsleitung 28 an ein programmierbares digitales Hochpaß-Filter 29 angeschlossen. Das programmierbare digitale Hochpaß-Filter 29 ist über eine Leitung 30 mit einem programmierbaren digitalen Tiefpaß-Filter 34 in Reihe geschaltet. Die Einstell-Filterkoeffizienten des programmierbaren digitalen Hochpaß-Filters 29 sind in einer zugehörigen Speichereinrichtung 32 abspeicherbar. Die Einstell-Filterkoeffizienten des programmierbaren digitalen Tiefpaß-Filters 31 sind in einer zugehörigen Speichereinrichtung 33 abspeicherbar. Die Speichereinrichtungen 32, 33 sind vorzugsweise wahlfreie Zugriffspeicher (RAM). Die dort abgespeicherten Einstell-Filterkoeffizienten können durch die Signal-Erkennungseinrichtung 24 umprogrammiert werden. Hierzu sind die Speichereinrichtungen 32, 33 über interne Speichereinstelleitungen 34, 35, 36 an den Steueranschluß 27 angeschlossen.

Das programmierbare digitale Tiefpaß-Filter 31 ist ausgangsseitig über eine interne Ausgangsleitung 37 mit dem Ausgangsanschluß 26 des programmierbaren digitalen Bandpaß-Filters 6 verbunden.

Bei der in Fig. 2 gezeigten Ausführungsform ist das programmierbare digitale Tiefpaß-Filter 31 dem programmierbaren digitalen Hochpaß-Filter 29 nachgeschaltet. Bei einer alternativen Ausführungsform ist das programmierbare digitale Hochpaß-Filter 29 dem programmierbaren digitalen Tiefpaß-Filter 31 nachgeschaltet.

Bei weiteren Ausführungsformen des erfindungsgemäßen programmierbaren digitalen Bandpaß-Filters können eine Vielzahl von programmierbaren digitalen Hochpaß-Filter 29 und eine Vielzahl von programmierbaren digitalen Tiefpaß-Filtern 31 in Reihe geschaltet sein. Die programmierbaren digitalen Tiefpaß-Filter 31 können dabei gleichzeitig als Interpolations- und Dezimationsfilter ausgebildet sein.

Bei einer bevorzugten Ausführungsform des erfindungsgemäßen programmierbaren digitalen Bandpaß-Filters 6 sind die programmierbaren digitalen Filter 29, 31 als Filter siebter Ordnung ausgebildet.

Die in den Speichereinrichtungen 32, 33 abspeicherbaren Einstell-Filterkoeffizienten stellen über Leitungen 38, 39 die Filtercharakteristika der digitalen Filter 29, 31 ein.

Durch die Reihenschaltung des programmierbaren digitalen Hochpaß-Filters 29 und eines programmierbaren digitalen Tiefpaß-Filters 31 wird eine Bandpaß-Filtercharakteristik erreicht. Durch die Einstell-Filterkoeffizienten ist dabei die obere und die untere Signalübertragungs-Grenzfrequenz des erfindungsgemäßen digitalen Bandpaß-Filters 6 sowie die Steilheit der Bandpaß-Filterplanken unabhängig voneinander einstellbar. Jedoch kann der erfindungsgemäße programmierbare digitale Bandpaß-Filter flexibel auf die individuellen Anforderungen des Übertragungskanals sowie auf die Art der verwendeten Modems eingestellt werden.

Dabei ist die untere Grenzfrequenz der Bandpaß-Filtercharakteristik durch die Einstellung der Einstell-Filterkoeffizienten des digitalen Hochpaß-Filters 29 einstellbar, und die obere Signalübertragungs-Grenzfrequenz der Bandpaß-Filtercharakteristik durch Einstellen der Einstell-Filterkoeffizienten des digitalen Tiefpaß-Filters 31 einstellbar.

Bei einer bevorzugten Ausführungsform sind die Frequenzgangkorrektur-Filter 10, 13, wie sie in Fig. 1 dargestellt sind, in dem programmierbaren digitalen Bandpaß-Filter 6 integriert, wobei der Ausgleich der Welligkeit der Bandpaß-Filtercharakteristik automatisch in Abhängigkeit von den eingestellten Filterkoeffizienten erfolgt.

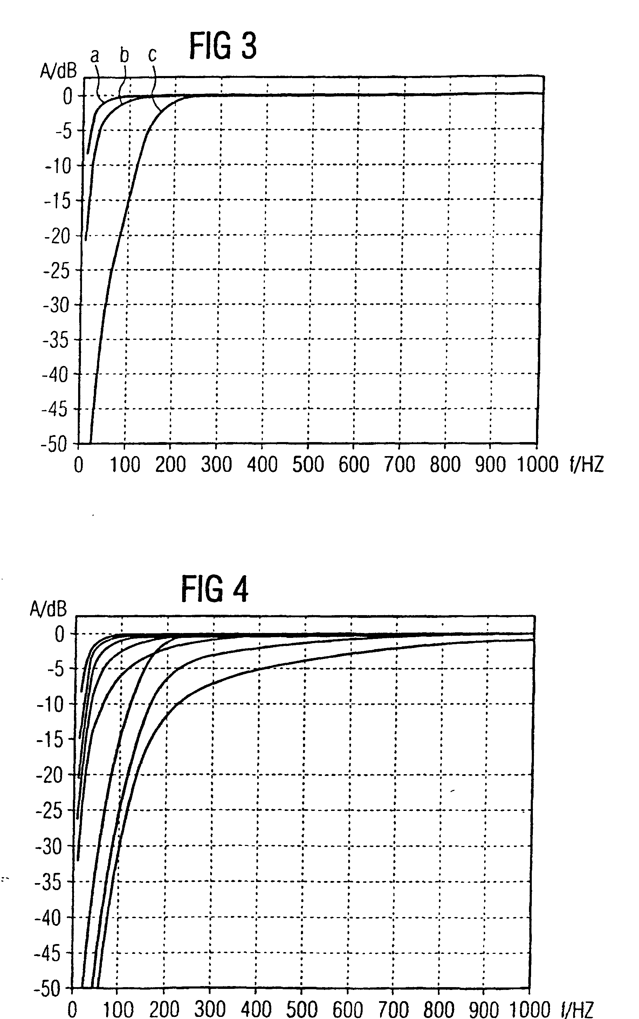

Fig. 3 zeigt die Frequenzgangcharakteristik der in Fig. 1 gezeigten Kodec-Schaltung im Bereich der unteren Grenzfrequenz. Wie aus Fig. 3 hervorgeht, liegt die untere Grenzfrequenz bei etwa 100 bis 200 Hz.

Die Filterübertragungskurve a zeigt die Filtereigenschaft der Kodec-Schaltung, wenn lediglich das Vorfilter 2 entsprechend dem über die Steuerleitung 11 zugeführten Einschalt-Steuersignal eingeschaltet ist. Die Filterübertragungskurve b zeigt den Zustand, wenn zusätzlich das fest eingestellte digitale Hochpaß-Filter 8 mittels eines Steuersignals auf der Steuerleitung 12 im Sendesignalpfad der Kodec-Schaltung geschaltet ist. Die Filterübertragungskurve c stellt schließlich den Zustand dar, bei dem das programmierbare digitale Hochpaß-Filter 29 des erfindungsgemäßen programmierbaren digitalen Bandpaß-Filters 6 zusätzlich in den Sendesignalpfad der Kodec-Schaltung geschaltet wird. Das Zuschalten des digitalen programmierbaren Bandpaß-Filters 6 in den Signalsendepfad erfolgt vorzugsweise durch die Signal-Erkennungseinrichtung 24 automatisch bei Erkennung eines entsprechenden PCM-Signals über eine separate Steuerleitung.

Wie man aus Fig. 3 erkennen kann, ist die untere Grenzfrequenz der Kodec-Schaltung bei Hinzuschalten des erfindungsgemäßen digitalen Bandpaß-Filters 6 erhöht und liegt bei etwa 200 Hz. Die untere Grenzfrequenz der Kodec-Schaltung ist somit individuell in Abhängigkeit von dem übertragenen PCM-Signal einstellbar. Bei dem in Fig. 3 gezeigten Beispiel wird die Grenzfrequenz im Bereich von 50 Hz bis 200 Hz eingestellt.

Fig. 4 zeigt die Filterübertragungscharakteristik der in Fig. 1 gezeigten Kodec-Schaltung bei Hinzuschalten der verschiedenen Hochpaß-Filter, d.h. des analogen Vorfilters 2, des digi talen programmierbaren Hochpaß-Filters 29 innerhalb des digitalen programmierbaren Bandpaß-Filters sowie des festen digitalen Hochpaß-Filters 8. Dabei wird in Fig. 4 im Gegensatz zu Fig. 3 zusätzlich die Veränderung der Filtercharakteristik in Abhängigkeit von eingestellten Filterkoeffizienten gezeigt. Wie aus Fig. 4 hervorgeht, wird nicht nur die untere Signalübertragungs-Grenzfrequenz der Kodec-Schaltung durch die Einstell-Filterkoeffizienten verändert, sondern auch zusätzlich die Steilheit der unteren Bandpaß-Filterflanke. Hierdurch ist eine Feineinstellung der Kodec-Schaltung möglich.

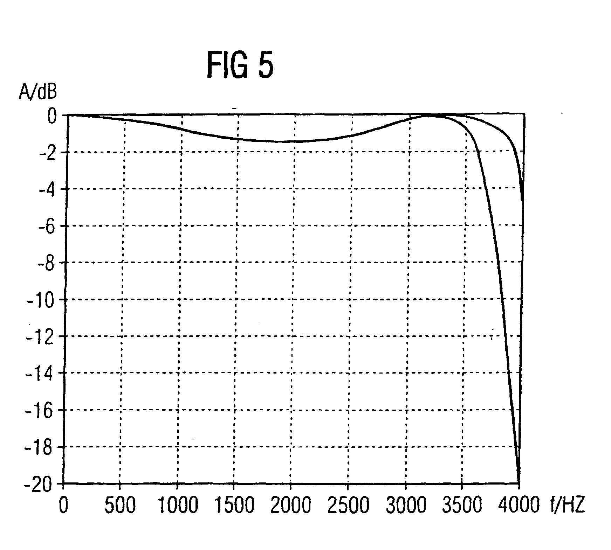

Fig. 5 zeigt die Filter-Übertragungscharakteristik des digitalen programmierbaren Tiefpaß-Filters 31 innerhalb des programmierbaren digitalen Bandpaß-Filters 6. Durch Umschalten auf andere Filterkoeffizienten des digitalen programmierbaren Tiefpaß-Filters 31 wird, wie aus Fig. 5 hervorgeht, die obere Grenzfrequenz erniedrigt.

Wie man aus den Fig. 3 bis 5 erkennen kann, wird durch Hinzuschalten des programmierbaren digitalen Bandpaß-Filters 6 der Durchlaß-Frequenzbereich verkleinert, da die untere Grenzfrequenz erhöht und die obere Grenzfrequenz vermindert wird. Umgekehrt wird durch das Umschalten von Koeffizienten des programmierbaren digitalen Bandpaß-Filters 6 der Durchlaß-Frequenzbereich ausgeweitet und damit die Datenübertragungsrate erhöht.

Die Filterübertragungscharakteristik kann in dem Sendesignalpfad und dem Empfangssignalpfad der Kodec-Schaltung unterschiedlich programmiert werden. Beispielsweise kann bei einem V.90-Modem die Senderichtung auf eine V.34-Modem-Übertragung angepaßt werden durch eine höhere obere Grenzfrequenz des digitalen programmierbaren Hochpaß-Filters 29 in dem im Empfangssignalpfad geschalteten programmierbaren digitalen Bandpaß-Filter 6, während in Empfangsrichtung die volle Frequenz bandbreite zur Verfügung gestellt wird. Durch Verwendung der erfindungsgemäßen programmierbaren digitalen Bandpaß-Filter 6 innerhalb der Kodec-Schaltung ist es möglich, den Frequenzbereich insbesondere bei Endgeräten bzw. Modems weitestgehend auszunützen. Das programmierbare digitale Bandpaß-Filter 6 gemäß der Erfindung bietet ferner die Möglichkeit, die Grenzfrequenzen unabhängig voneinander zu programmieren.

Damit können einerseits die vorgegebenen Spezifikationen bei der Sprachübertragung erfüllt und andererseits eine optimale Ausnützung des Frequenzbereichs bei Modem-Signalübertragungen erreicht werden.

## Patentansprüche

1. Kodec-Schaltung mit einem programmierbaren digitalen Bandpaß-Filter (6) zur Anpassung der Filtereigenschaften der Kodec-Schaltung an ein übertragenes PCM-Signal mit mindestens einem programmierbaren digitalen Hochpaß-Filter (29) und mindestens einem dazu in Reihe geschalteten programmierbaren digitalen Tiefpaß-Filter (31), wobei die Einstell-Filterkoeffizienten des programmierbaren digitalen Hochpaßund Tiefpaß-Filters (29, 31) jeweils in Abhängigkeit von dem übertragenen PCM-Signal zur Veränderung einer Bandpaß-Filtercharakteristik des programmierbaren digitalen Bandpaß-Filters (6) durch eine Signalerkennungseinrichtung (24) zur Identifikation des durch die Kodec-Schaltung übertragenen PCM-Signals einstellbar sind.

2. Kodec-Schaltung nach Anspruch 1,
**dadurch gekennzeichnet,**
**daß** die Einstell-Filterkoeffizienten in Koeffizienten-Speichereinrichtungen (32, 33) abspeicherbar sind, die den programmierbaren digitalen Hochpaß- und Tiefpaß-Filtern (29, 31) zugeordnet sind.

3. Kodec-Schaltung nach Anspruch 1 oder 2,
**dadurch gekennzeichnet,**
**daß** die Speichereinrichtungen (32, 33) wahlfreie Zugriffsspeicher (RAM) sind.

4. Kodec-Schaltung nach einem der vorangehenden Ansprüche 1 bis 3,
**dadurch gekennzeichnet,**
**daß** die Speichereinrichtungen (32, 33) über Koeffizienten-Einstelleitungen (22, 23) mit der Signal-Erkennungseinrichtung (24) verbunden sind.

5. Kodec-Schaltung nach einem der vorangehenden Ansprüche 1 bis 4,
**dadurch gekennzeichnet,**
**daß** die programmierbaren digitalen Filter (29, 31) jeweils Filter siebter Ordnung sind.

6. Kodec-Schaltung nach einem der vorangehenden Ansprüche 1 bis 5,
**dadurch gekennzeichnet,**
**daß** durch die Einstell-Filterkoeffizienten die obere und untere Signalübertragungs-Grenzfrequenz des Bandpaß-Filters (6) und die Steilheit der Bandpaß-Filterflanken einstellbar ist.

7. Kodec-Schaltung nach Anspruch 6,
**dadurch gekennzeichnet,**
**daß** die untere Signalübertragungs-Grenzfrequenz durch Einstellung der Einstell-Filterkoeffizienten des digitalen Hochpaß-Filters (29) einstellbar ist.

8. Kodec-Schaltung nach Anspruch 6,
**dadurch gekennzeichnet,**
**daß** die obere Signalübertragungs-Grenzfrequenz durch Einstellung der Einstell-Filterkoeffizienten des programmierbaren digitalen Tiefpaß-Filters (29) einstellbar ist.

9. Kodec-Schaltung nach einem der vorangehenden Ansprüche 1 bis 8,
**dadurch gekennzeichnet,**
**daß** zusätzlich ein Frequenzgangkorrektur-Filter (10, 13) zum Ausgleich der Welligkeit der Bandpaß-Filtercharakteristik im Durchlaßbereich vorgesehen ist.

## Claims

1. Codec circuit having a programmable digital bandpass filter (6), for matching the filter characteristics of the codec circuit to a transmitted PCM signal, having at least one programmable digital high-pass filter (29) and at least one programmable digital low-pass filter (31) connected in series with it, in which case the setting filter coefficients for the programmable digital high-pass and low-pass filters (29, 31) can each be set, by means of a signal identification device (24) for identification of a PCM signal transmitted through the codec circuit, as a function of the transmitted PCM signal in order to vary a bandpass filter characteristic for the programmable digital bandpass filter (6).

2. Codec circuit according to Claim 1, **characterized in that** the setting filter coefficients can be stored in coefficient memory devices (32, 33) which are associated with the programmable digital high-pass and low-pass filters (29, 31).

3. Codec circuit according to Claim 1 or 2, **characterized in that** the memory devices (32, 33) are random access memories (RAM).

4. Codec circuit according to one of the preceding Claims 1 to 3,
**characterized in that**
the memory devices (32, 33) are connected via coefficient setting lines (22, 23) to the signal identification device (24).

5. Codec circuit according to one of the preceding Claims 1 to 4, **characterized in that** the programmable digital filters (29, 31) are each seventh-order filters.

6. Codec circuit according to one of the preceding Claims 1 to 5, **characterized in that** the upper and lower signal transmission cut-off frequencies of the bandpass filter (6) and the gradient of the bandpass filter flanks can be set by means of the setting filter coefficients.

7. Codec circuit according to Claim 6, **characterized in that** the lower signal transmission cut-off frequency can be set by setting the setting filter coefficients of the digital high-pass filter (29).

8. Codec circuit according to Claim 6, **characterized in that** the upper signal transmission cut-off frequency can be set by setting the setting filter coefficients of the programmable digital low-pass filter (29).

9. Codec circuit according to one of the preceding Claims 1 to 8, **characterized in that** a frequency response correction filter (10, 13) is also provided, in order to compensate for the ripple in the bandpass filter characteristic in the passband.

## Revendications

1. Circuit codec comportant un filtre passe-bande numérique programmable (6) pour adapter les caractéristiques de filtre du circuit codec à un signal MIC transmis, comportant au moins un filtre passe-haut numérique programmable (29) et au moins un filtre passe-bas numérique programmable (31) branché en série avec le filtre passe-haut, les coefficients de réglage du filtre passe-haut et du filtre passe-bas numérique programmables (29,31) étant réglables respectivement en fonction du signal MIC transmis, pour modifier une caractéristique du filtre passe-bande numérique programmable (6) au moyen d'un dispositif (24) de reconnaissance de signaux pour l'identification du signal MIC transmis par le circuit codec.

2. Circuit codec selon la revendication 1,
**caractérisé en ce que** les coefficients de réglage peuvent être mémorisés dans des dispositifs (32,33) de mémoire de coefficients, qui sont associés aux filtres passe-haut et passe-bas numériques programmables (29,31).

3. Circuit codec selon la revendication 1 ou 2,
**caractérisé en ce que** les dispositifs de mémoire (32,33) sont des mémoires à accès direct (RAM).

4. Circuit codec selon l'une des revendications précédentes 1 à 3, **caractérisé en ce que** les dispositifs de mémoire (32,33) sont reliés au moyen de lignes (22,23) de réglage de coefficients au dispositif (24) de reconnaissance de signaux.

5. Circuit codec selon l'une des revendications précédentes 1 à 4, **caractérisé en ce que** les filtres numériques programmables (29,31) sont respectivement des filtres du septième ordre.

6. Circuit codec selon l'une des revendications précédentes 1 à 5, **caractérisé en ce que** les fréquences limites supérieure et inférieure de transmission de signaux du filtre passe-bande (6) et la pente des flancs du filtre passe-bande sont réglables au moyen des coefficients de réglage.

7. Circuit codec selon la revendication 6,
**caractérisé en ce que** la fréquence limite inférieure de transmission de signaux est réglable au moyen du réglage des coefficients de réglage du filtre passe-haut numérique (29).

8. Circuit codec selon la revendication 6,
**caractérisé en ce que** la fréquence limite supérieure de transmission de signaux est réglable au moyen du réglage des coefficients de réglage du filtre passe-bas numérique programmable (29).

9. Circuit codec selon l'une des revendications 1 à 8, **caractérisé en ce qu'**il est prévu en supplément un filtre (10,13) de correction de la réponse en fréquence pour la compensation de l'ondulation de la caractéristique du filtre passe-bande dans la bande passante.
